# EUROPEAN PATENT APPLICATION

(11) **EP 2 416 382 A1**
(43) Date of publication of application: **08.02.2012**
(21) Application number: 10761357.2
(22) Date of filing: 26.03.2010
(51) Int. Cl.: H01L 31/042, B32B 5/20, B32B 27/18

(54) **PROTECTIVE SHEET FOR SOLAR CELL MODULE UNDERSIDES, SOLAR CELL MODULE PROVIDED THEREWITH, AND METHOD FOR MANUFACTURING SAID SOLAR CELL MODULES**

(30) Priority: 30.03.2009 JP 2009081036
(71) Applicant: Lintec Corporation, Tokyo 173-0001 (JP)
(72) Inventor: TAKANASHI, Yasunari, Tokyo 173-0001 (JP); KAMESHIMA, Atsuko, Tokyo 173-0001 (JP); HOSHI, Shinichi, Tokyo 173-0001 (JP)
(74) Representative: Jansen, Cornelis Marinus
(86) International application number: PCT/JP2010/002159
(87) International publication number: WO 2010/116649

(57) **Abstract**

A back protective sheet for a solar cell module in which a thermoplastic resin sheet containing heat-expandable particles is formed on at least one side of a base sheet, a solar cell module having this back protective sheet for a solar cell module, and a production method of this solar cell module.

## Description

### TECHNICAL FIELD

The present invention relates to a back protective sheet for a solar cell module. Moreover, the present invention relates to a solar cell module equipped with the back protective sheet for a solar cell module, and a method of producing the solar cell module.
The present application claims priority on the basis of Japanese Patent Application No. 2009-81036 filed in Japan on March 30, 2009, the contents of which are incorporated herein by reference.

### BACKGROUND ART

Solar cell modules are devices that convert light energy from the sun into electrical energy, and are attracting attention as systems capable of generating electrical power without discharging carbon dioxide.

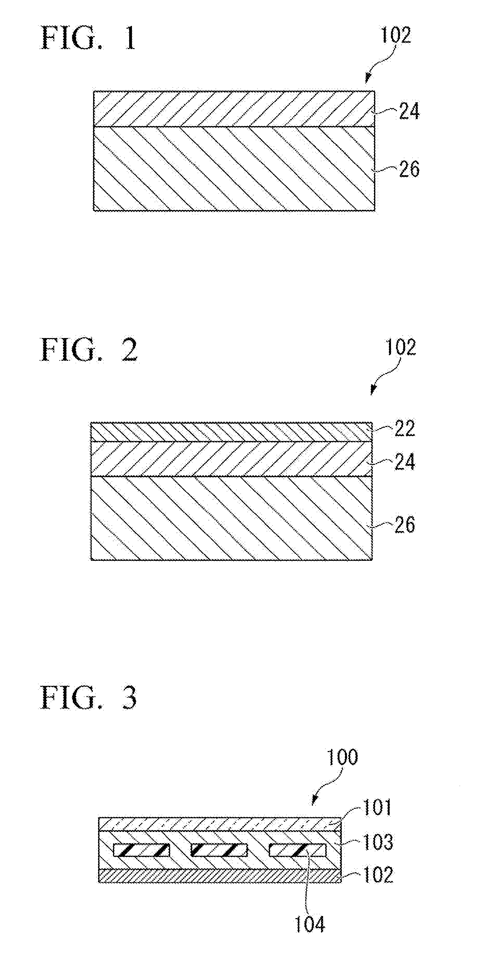

FIG. 3 is a schematic cross-sectional view showing an example of a typical solar cell module.
This solar cell module 100 is mainly composed of solar cells 104 composed of crystalline silicone or amorphous silicon, an encapsulant (filler layer) 103 composed of an electrical insulator that encapsulates the solar cells 104, a translucent front protective sheet (front sheet) 101 laminated on the front side of the encapsulant 103, and a back protective sheet (back sheet) 102 laminated on the back side of the encapsulant 103. Furthermore, the front sheet 101 may also have a glass plate for the base.

In the present description and claims, the translucent front protective sheet (front sheet) 101 and the back protective sheet (back sheet) 102 may be collectively referred to as "protective sheets".

In order to impart weather resistance and durability to a solar cell module enabling it to withstand outdoor and indoor use over a long period of time, it is necessary to protect the solar cells 104 and the encapsulant 103 from wind and rain, humidity, debris and mechanical impacts while also maintaining the inside of the solar cell module in an encapsulated state that is isolated from the outside air. Consequently, the protective sheets 101 and 102 for a solar cell module are required to have superior weather resistance.

In addition, the back protective sheet 102 is also required to have high light reflectivity in order to reduce as much as possible optical reception loss caused by light, which has entered from the light receiving surface on the side of the translucent front protective sheet 101 of the solar cell module 100, escaping to the back side through gaps between the plurality of solar cells 104, and because of this, it is necessary to impart the back protective sheet 102 with a function that enhances electrical power generation efficiency by reflecting light that has escaped through gaps between the solar cells 104, returning it to the side of the solar cells 104 and reducing optical reception loss.

Moreover, in reflection of the increasingly high level of performance of solar cell modules in recent years, the standard system voltage of solar cell modules has reached 1000 V or more, thereby requiring the back protective sheet to also have high electrical insulating properties.

Back protective sheets have been previously proposed that contain titanium dioxide in a thermoplastic resin sheet in order to enhance light reflectivity (see Patent Document 1).
In addition, back protective sheets have also been previously proposed that contain air bubbles in an adhesive that adheres a white plastic film and a gas barrier vapor deposition film in order to enhance light reflectivity and electrical insulating properties (see Patent Document 2).

### [Prior Art Documents]

### [Patent Documents]

[Patent Document 1] Japanese Unexamined Patent Application, First Publication No. 2006-270025
[Patent Document 2] Japanese Unexamined Patent Application, First Publication No. 2008-270238

### SUMMARY OF THE INVENTION

### [Problems to be Solved by the Invention]

However, the back protective sheet that only contains titanium dioxide in a thermoplastic sheet proposed in Patent Document 1 has inadequate light reflectivity.
In addition, in the back protective sheet proposed in Patent Document 2, it is difficult to control the size and number of bubbles contained in the adhesive, the adhesive strength is weakened as a result of containing air bubbles in the adhesive layer, and interlayer separation tends to occur easily.

With the foregoing in view, an object of the present invention is to provide a back protective sheet for a solar cell module that has superior light reflectivity and electrical insulating properties. In addition, an object of the present invention is to provide a solar cell module obtained by using this back protective sheet for a solar cell module.

### [Means for Solving the Problems]

The present invention employs the following configuration in order to achieve the aforementioned objects.
Namely, the present invention is a back protective sheet for a solar cell module in which a thermoplastic resin sheet containing heat-expandable particles is formed on at least one side of a base sheet.
In the back protective sheet for a solar cell module of the present invention, the heat-expandable particles are preferably contained at a ratio of 0.1% by weight to 30% by weight in the thermoplastic resin sheet.
In the back protective sheet for a solar cell module of the present invention, the particle diameter of the heat-expandable particles prior to thermal expansion is preferably 5 µm to 150 µm.
In the back protective sheet for a solar cell module of the present invention, the thermal expansion starting temperature of the heat-expandable particles is preferably equal to or higher than the softening temperature of the thermoplastic resin that composes the thermoplastic resin sheet.
In the back protective sheet for a solar cell module of the present invention, the thermal expansion starting temperature of the heat-expandable particles is preferably within the range of 85°C to 180°C.
In addition, the present invention is a production method of a solar cell module comprising adhesion of the back protective sheet for a solar cell module to the back side of an encapsulant, which encapsulates solar cells, by heating.
In addition, the present invention is a solar cell module having solar cells, an encapsulant that encapsulates the solar cells, and a back protective sheet laminated onto the encapsulant, wherein
the back protective sheet is composed of the back protective sheet for a solar cell module of the present invention, and
the back protective sheet is laminated onto the encapsulant through the thermoplastic resin sheet interposed there between.

In the present description and claims, the softening temperature of the thermoplastic resin that composes the thermoplastic resin sheet composing the back protective sheet for a solar cell module is the Vicat softening temperature (Vicat softening point) stipulated in Japanese Industrial Standard JIS K7206:1999.

### [Effects of the Invention]

Since a thermoplastic resin sheet containing heat-expandable particles is formed on at least one side of a base sheet, pores, for which the size, number and dispersibility thereof are controlled, can be formed in the thermoplastic resin sheet, thereby enabling the back protective sheet for a solar cell module of the present invention to demonstrate superior light reflectivity and electrical insulating properties.
In addition, in a solar cell module obtained by using the back protective sheet for a solar cell module of the present invention, reflection efficiency of reflecting light that has escaped through gaps between the solar cells and returning it to the side of the solar cells is increased, thereby allowing the solar cell module to demonstrate superior electrical power generation efficiency. Moreover, this solar cell module is able to accommodate system voltages of 1000 V or more.

### BRIEF DESCRIPTION OF THE DRAWINGS

FIG. 1 i a cross-sectional view of a first embodiment of a protective sheet for a solar cell module of the present invention.
FIG. 2 is a cross-sectional view of a second embodiment of a protective sheet for a solar cell module of the present invention.
FIG. 3 is a schematic diagram showing the configuration of a solar cell module.

### EMBODIMENTS OF THE INVENTION

The following provides an explanation of embodiments of the present invention with reference to the drawings.

### <First Embodiment>

FIG. 1 is a schematic cross-sectional view showing a first embodiment of the back protective sheet for a solar cell module of the present invention (to also be referred to as the back protective sheet).
A back protective sheet 102 of the present invention shown in FIG. 1 has a thermoplastic resin sheet 26 containing heat-expandable particles formed on at least one side of a base sheet 24.

In the back protective sheet 102, the thermoplastic resin sheet 26 containing heat-expandable particles may be formed only on one side of the base sheet 24 (FIG. 1), or may be formed on both sides of the base sheet 24.

A known material used in back protective sheets for solar cell modules can be used for the back sheet 24 within a range that does not impair the effects of the present invention, and examples of materials that can be used include metal foils and resin films.

Examples of metal foils used for the base sheet 24 include metal foils such as aluminum foil, copper foil or iron foil, and aluminum foil is preferable.
In this case, the weather resistance and water vapor impermeability of the back protective sheet 102 can be further improved. However, in the case of using the metal foil for the base sheet 24, it is normally necessary to suitably adjust the thickness of the thermoplastic resin sheet and/or laminate a resin sheet having high electrical insulating properties in addition to the thermoplastic resin sheet 26 in order to enhance the electrical insulating properties of the back protective sheet 102.

A resin film typically used as a resin film in a back protective sheet for a solar cell module can be used for the resin film in the base sheet 24. Examples of resin films include sheets composed of resins in the manner of polyolefin-based resins such as polyethylene or polypropylene, polyester-based resins such as polyethylene terephthalate (PET), polybutylene terephthalate (PBT) or polyethylene naphthalate (PEN), amide-based resins such as Nylon 6, Nylon 66, poly-m-phenylene isophthalamide or poly-p-phenylene terephthalamide, styrene-based resins, methacrylic-based resins, vinyl chloride-based resins, acetal-based resins, carbonate-based resins, urethane-based resins, ABS resins or vinyl alcohol-based resins, or films composed of mixtures of these resins. In addition, the base sheet 24 may be a single resin film or a laminate of a plurality of different resin films.
Among these, films composed of polyester-based resins are preferable, with PET film being more preferable. In addition, the base sheet 24 composed of a polyester-based resin film such as PET, PBT or PEN is more preferably imparted with hydrolysis resistance using a known method. In the case of using these preferable resin films for the base sheet 24, the water vapor impermeability, electrical insulating properties, heat resistance and chemical resistance of the back protective sheet 102 can be further improved.

Furthermore, the aforementioned resin film may also contain various types of additives such as organic fillers, inorganic fillers or ultraviolet absorbers. In addition, a vapor deposition layer may be further provided on the surface of the base sheet 24 to enhance weather resistance, moisture resistance and the like. The vapor deposition layer is formed by a chemical vapor deposition method such as plasma chemical vapor phase growth, thermochemical vapor phase growth or photochemical vapor phase growth, or a physical vapor phase method such as vacuum deposition, sputtering or ion plating. The vapor deposition layer is composed of an inorganic oxide, and that composed of a metal oxide such as silicon dioxide (SiO₂) or aluminum oxide (Al₂O₃) is preferable. The vapor deposited layer may be composed of one type of metal oxide or may be composed of a plurality of types of metal oxides. Furthermore, vapor deposition treatment may be carried out on both sides or on only one side of the base sheet 24.

The thickness of the base sheet 24 is adjusted based on the electrical insulating properties required by the solar cell system, and normally the thickness of the base sheet 24 is preferably within the range of 10 µm to 300 µm. More specifically, in the case the resin film is a PET film provided with hydrolysis resistance, the thickness of the PET film is preferably within the range of 10 µm to 300 µm and more preferably within the range of 30 µm to 200 µm, from the viewpoints of light weight and electrical insulating properties.

There are no particular limitations on the thermoplastic resin that composes the thermoplastic resin sheet 26 in the back protective sheet 102 of the present invention provided it satisfies the following two conditions:
condition (1): heat-expandable particles to be subsequently described are contained in a dispersed state; and
condition (2): pores are formed in the thermoplastic resin sheet 26 by expansion of the heat-expandable particles when the thermoplastic sheet 26 has been heated to a temperature equal to higher than the softening temperature of the thermoplastic resin.

Examples of thermoplastic resins that satisfy the conditions (1) and (2) include resins in the manner of polyolefin-based resins such as polyethylene or polypropylene, styrene-based resins, methacrylic-based resins, fluorine-based resins such as polytetrafluoroethylene, amide-based resins such as Nylon 6, Nylon 66, poly-m-phenyleneisophthalamide or poly-p-phenyleneterephthalamide, acrylonitrile-based resins, vinyl chloride-based resins, vinylidene chloride-based resins, vinyl alcohol-based resins, polyester-based resins such as polyethylene terephthalate (PET), polybutylene terephthalate (PBT) or polyethylene naphthalate (PEN), acetal-based resins, carbonate-based resins, butadiene-based resins, ester urethane-based resins, acrylonitrile-styrene copolymer resins (AS resins), acrylonitrile-butadiene-styrene copolymer resins (ABS resins), methyl methacrylate-butadiene-styrene copolymer resins (MBS resins), ethylene-methyl methacrylate copolymer resins (EMMA resins) and ethylene-vinyl acetate copolymer resins (EVA).

The thermoplastic resin sheet 26 preferably has thermal adhesiveness. In this case, the side of the back protective sheet 102 on which the thermoplastic resin sheet 26 is formed can be thermally adhered to the encapsulating side of the encapsulant 103 of the solar cell module 100.
Here, thermal adhesiveness refers to a property enabling the demonstration of adhesiveness as a result of heating treatment. The temperature of this heating treatment is normally within the range of 50°C to 200°C.

The thermoplastic resin having thermal adhesiveness is preferably a resin composed of a polymer mainly composed of EVA and polyolefin, and a resin composed of a polymer mainly composed of EVA is more preferable.
In general, the encapsulant 103 is frequently an encapsulating resin composed of EVA, and in this case, by making the thermoplastic resin sheet 26 to be a resin composed of a polymer mainly composed of EVA as described above, compatibility and adhesion between the encapsulant 103 and the thermoplastic resin sheet 26 can be improved.

In the back protective sheet 102 of the present invention, in the case of using EVA for the thermoplastic resin that composes the thermoplastic resin sheet 26, the content of vinyl acetate is preferably 3% by weight to 90% by weight, and more preferably 5% by weight to 80% by weight. If the content of vinyl acetate is within these preferable ranges, the aforementioned conditions (1) and (2) can be satisfied even more adequately.

In addition, the softening temperature of the thermoplastic resin that composes the thermoplastic resin sheet 26 in the back protective sheet 102 of the present invention is preferably 0°C or higher, more preferably 25°C or higher, and even more preferably 40°C or higher. The upper limit thereof is preferably 100°C, more preferably 80°C and even more preferably 60°C. If the softening temperature is within these preferable ranges, the aforementioned condition (2) can be satisfied even more adequately.

The thermoplastic resin that composes the thermoplastic resin sheet 26 may be composed of only one type of thermoplastic resin or may be obtained by mixing two or more types of thermoplastic resins provided the conditions (1) and (2) are satisfied.

There are no particular limitations on the heat-expandable particles contained in the thermoplastic resin sheet 26 in the back protective sheet 102 of the present invention provided they satisfy the following two conditions:
condition (A): the heat-expandable particles are contained in the thermoplastic resin in a dispersed state; and
condition (B): the heat-expandable particles form pores in the thermoplastic resin sheet 26 as a result of expanding due to an increase in temperature brought about by heating treatment when the thermoplastic resin sheet 26 is heated to a temperature equal to or higher than the softening temperature of the thermoplastic resin.

The heat-expandable particles contained in the thermoplastic resin sheet 26 of the back protective sheet 102 of the present invention have the property of expanding due to an increase in temperature as a result of heating treatment.

As a result of heating the back protective sheet 102 in which the thermoplastic resin sheet 26 is formed, the heat-expandable particles expand and form pores by pushing apart the thermoplastic resin around the heat-expandable particles. When heating is subsequently discontinued and the thermoplastic resin sheet 26 is returned to room temperature, the hardness of the thermoplastic resin sheet returns to its normal state and the porous structure is maintained.

The number of pores (density) formed in the thermoplastic resin sheet 26 can be easily adjusted by heating treatment by adjusting the number (concentration) of the heat-expandable particles contained in the thermoplastic resin sheet 26. Moreover, the size of pores formed in the thermoplastic resin sheet 26 can be easily adjusted by heating treatment by adjusting the size (particle diameter) of the heat-expandable particles contained in the thermoplastic resin sheet 26. As a result, the light reflectivity and electrical insulating properties of the back protective sheet 102 can be easily controlled, thereby making this advantageous.

In addition, by carrying out heating treatment when the side of the back protective sheet 102 on which the thermoplastic resin sheet 26 is formed is thermally adhered to the encapsulating side of the encapsulant 103 of the solar cell module 100, the thermoplastic resin sheet 26 can be heat-treated simultaneous to thermal adhesion and a porous structure can be formed in the thermoplastic resin sheet 26, thereby making this advantageous from the viewpoint of shortening the production process of the solar cell module 100.

In the back protective sheet 102 of the present invention, the heat-expandable particles are preferably contained in the thermoplastic resin sheet 26 at a ratio of 0.1% by weight to 30% by weight, more preferably at a ratio of 0.5% by weight to 25% by weight, and even more preferably at a ratio of 1.0% by weight to 20% by weight. Here, the ratio (content ratio) refers to the ratio when the total weight of the solid components contained in the thermoplastic resin sheet 26 is 100% by weight. Examples of solid components include heat-expandable particles, resin and pigment to be subsequently described. However, in the case heat-expandable particles are contained in a liquid component, since the weight of the liquid in which they are contained is included in the weight of the heat-expandable particles, it is included in the weight of the solid components.
If the ratio of the heat-expandable particles contained in the thermoplastic resin sheet is equal to or greater than the lower limit of the aforementioned ranges, an adequate number of pores (air bubbles) can be formed in the thermoplastic resin sheet 26, and as a result thereof, light reflectivity and electrical insulating properties of the back protective sheet 102 can be further enhanced. If the ratio is equal to or less than the upper limit of the aforementioned ranges, the strength of the thermoplastic resin sheet 26 can be maintained and pores (air bubbles) formed by heating treatment are easily formed as mutually independent pores (closed pores).

In the back protective sheet 102 of the present invention, the particle diameter of the heat-expandable particles is preferably 5 µm to 150 µm, more preferably 5 µm to 100 µm, and even more preferably 10 µm to 80 µm.
If the particle diameter is within the aforementioned ranges, the heat-expandable particles can be adequately dispersed within the thermoplastic resin sheet 26, and the size of pores formed after thermal expansion in the thermoplastic resin sheet 26 is preferable from the viewpoints of enhancing light reflectivity and electrical insulating properties of the back protective sheet 102.

In the back protective sheet 102 of the present invention, the thermal expansion starting temperature (temperature at which thermal expansion is initiated) of the heat-expandable particles is preferably equal to or higher than the softening temperature of the thermoplastic resin that composes the thermoplastic resin sheet.
More specifically, the thermal expansion starting temperature is preferably a temperature that is 1°C or more higher, more preferably 5°C or more higher, and even more preferably 10°C or more higher than the softening temperature of the thermoplastic resin.
Even more specifically, the thermal expansion starting temperature is preferably 85°C to 180°C, more preferably 85°C to 160°C, and even more preferably 85°C to 140°C.
If the thermal expansion starting temperature is equal to or greater than the lower limit value of the aforementioned ranges, pores can be more adequately formed in the thermoplastic resin sheet 26 by carrying out heating treatment on the back protective sheet 102 at a temperature higher than the lower limit value, and as a result thereof, the light reflectivity and electrical insulating properties of the back protective sheet 102 can be further enhanced. If the thermal expansion starting temperature is equal to or less than the upper limit value of the aforementioned ranges, the strength of the thermoplastic resin sheet 26 can be maintained, and pores (air bubbles) formed by heating treatment are easily formed as mutually independent pores (closed pores).

Encapsulated particles, in which a heat-expandable substance is contained in a shell (to be referred to as microcapsules) constitute a preferable example of the heat-expandable particles.

There are no particular limitations on the substance that composes the outer shell of the microcapsules provided the volume of the microcapsules increases due to swelling pressure when the volume of the heat-expandable substance contained therein has expanded due to heating treatment, thermoplastic substances are typically used, and preferable examples include resins such as vinylidene chloride-acrylonitrile copolymer, polyvinyl alcohol, polyvinyl butyrate, polymethyl methacrylate, polyacrylonitrile, polyvinylidene chloride and polysulfone.

There are no particular limitations on the heat-expandable substance contained in the microcapsules provided it gasifies and expands due to heating treatment and causes the microcapsules to expand accompanying that expansion, and preferable examples include organic compounds such as isobutane, propane or pentane. The aforementioned organic compounds are preferable since they easily gasify and expand when subjected to heating treatment. In addition, water can also be used for the heat-expandable substance.

The microcapsules can be produced by a known, commonly used method such as coacervation or interfacial polymerization. In addition, commercially available microcapsules can also be used, and for example, Matsumoto Microspheres (trade name) manufactured by Matsumoto Yushi-Seiyaku Co., Ltd., Kureha Microspheres (trade name) manufactured by Kureha Corp., or Daifoam (trade name) manufactured by Dainichiseika Color & Chemicals Mfg. Co., Ltd. can be used preferably.

The thermal expansion starting temperature (temperature at which thermal expansion is initiated) of the microcapsules is preferable equal to or higher than the softening temperature of the thermoplastic resin that composes the thermoplastic resin sheet 26.
More specifically, the thermal expansion starting temperature is preferably 1°C or more higher, more preferably 5°C or more higher, and even more preferably 10°C or more higher than the softening temperature of the thermoplastic resin.
Even more specifically, the thermal expansion starting temperature is preferably 85°C to 180°C, more preferably 85°C to 160°C and even more preferably 85°C to 140°C.
If the thermal expansion starting temperature is equal to or greater than the lower limit value of the aforementioned ranges, pores can be more adequately formed in the thermoplastic resin sheet 26 as a result of heating treatment of the back protective sheet 102 at a temperature higher than the lower limit value, and as a result thereof, the light reflectivity and electrical insulating properties of the back protective sheet 102 can be further enhanced. If the thermal expansion starting temperature is equal to or less than the upper limit value of the aforementioned ranges, the strength of the thermoplastic resin sheet 26 can be maintained, and pores (air bubbles) formed by heating treatment are easily formed as mutually independent pores (closed pores).

The maximum expansion temperature of the microcapsules (temperature at which the particle diameter of the microcapsules reaches a maximum) is preferably within a range of 1°C to 165°C higher than the softening temperature of the thermoplastic resin that composes the thermoplastic resin sheet 26. More specifically, the maximum expansion temperature is more preferably 110°C to 270°C.
If the maximum expansion temperature is within the aforementioned ranges, pores formed by heating treatment are easily formed as mutually independent pores (closed pores).

In the thermoplastic resin sheet 26 of the back protective sheet 102 of the present invention, the pores formed following heating treatment are preferably closed pores.
If the pores (air bubbles) are mutually independent pores (closed pores), the strength of the thermoplastic resin sheet 26 can be adequately maintained, and the light reflectivity and electrical insulating properties of the back protective sheet 102 can be further enhanced.

The thermoplastic resin sheet 26 of the back protective sheet 102 of the present invention may also contain a pigment such as inorganic particles in addition to the heat-expandable particles. As a result of containing the pigment, the light reflectivity and water vapor impermeability of the back protective sheet 102 can be further enhanced, and functions such as ultraviolet blocking or coloring can be imparted to the back protective sheet 102.
Known pigments used in protective sheets for solar cell modules can be used for the pigment, examples of which include titanium oxide, magnesium oxide, zinc oxide, calcium carbonate, barium sulfate, talc, gypsum, alumina and carbon black.

Although there are no particular limitations on the content of the pigment in the thermoplastic resin sheet 26 provided it is within a range that does not impair the effects of the present invention, it is preferably 5% by weight to 60% by weight and more preferably 10% by weight to 40% by weight.

In the back protective sheet 102 of the present invention, there are no particular limitations on the method used to form the thermoplastic resin sheet 26 on the base sheet 24 provided it does not impair the effects of the present invention. For example, a coating liquid in which a thermoplastic resin containing heat-expandable particles is dissolved or dispersed in a solvent is coated onto the base sheet 24 followed by drying to form the thermoplastic resin sheet 26 in the form of a coated film, or may be formed by means of an adhesive layer provided between the base sheet 24 and the thermoplastic resin sheet 26.

The coating liquid is preferably prepared by dissolving or dispersing a thermoplastic resin containing the heat-expandable particles and a pigment in a solvent. The solvent used at this time can be suitably selected from known solvents. Examples of such solvents that can be used preferably include one type or two or more types selected from the group consisting of methyl ethyl ketone (MEK), cyclohexanone, acetone, methyl isobutyl ketone (MIBK), toluene, xylene, methanol, isopropanol, ethanol, heptane, ethyl acetate, isopropyl acetate, n-butyl acetate, n-butyl alcohol and water. One type of these solvents may be used alone or two or more types may be used in combination.
The concentration of the solid fraction of the coating liquid is preferably 30% by weight to 95% by weight and more preferably 35% by weight to 85% by weight.

In the case of providing an adhesive layer between the base sheet 24 and the thermoplastic resin sheet 26, the adhesive layer preferably contains an adhesive that demonstrates adhesion with respect to the base sheet 24 and the thermoplastic resin sheet 26.
There are no particular limitations on the adhesive provided it does not impair the effects of the present invention, and examples include acrylic-based adhesives, urethane-based adhesives, epoxy-based adhesives and ester-based adhesives. The side of the base sheet 24 and the thermoplastic resin sheet 26 that faces the adhesive layer may be subjected to corona treatment and/or chemical treatment in order to improve the adhesion thereof.

The coating liquid can be coated onto the base sheet 24 by a conventionally known coating method such as bar coating, reverse roll coating, knife coating, roll knife coating, gravure coating, air doctor coating or doctor blade coating.

The temperature in the case of drying a coated film formed on the base sheet 24 as the thermoplastic resin sheet 26 may be any temperature provided it does not impair the effects of the present invention, and is preferably within the range of 50°C to 120°C from the viewpoints of reducing the effect on the base sheet 24 and the effect on the heat-expandable particles.

The thickness of the thermoplastic resin sheet 26 in the back protective sheet 102 of the present invention may be adjusted based on the electrical insulation properties required by the solar cell system, and normally the thickness of the sheet is preferably 10 µm to 200 µm, more preferably 20 µm to 150 µm, and even more preferably 30 µm to 100 µm. However, the thickness of the thermoplastic resin sheet 26 is greater than the diameter (thickness) of the heat-expandable particles.
In addition, the sum of the thickness of the thermoplastic resin sheet 26 and the thickness of the base sheet 24 is preferably 150 µm to 300 µm and more preferably 150 µm to 250 µm from the viewpoint of accommodating the electrical insulating properties required by the solar cell system and from the viewpoint of light weight.

Electrical insulating properties of the back protective sheet 102 of the present invention are determined according to the partial discharge inception voltage as measured according to a partial discharge test.
The partial discharge test can be carried out using an alternative testing method complying with the specifications of EN50178.
The partial discharge inception voltage of the back protective sheet 102 of the present invention is preferably 1300 V or more, more preferably 1500 V or more, and even more preferably 1600 V or more.
If the back protective sheet 102 has a preferable measured value for partial discharge inception voltage as indicated above, then a solar cell module obtained by using the back protective sheet 102 can adequately accommodate a system voltage of 1000 V or more.

Light reflectivity of the back protective sheet 102 of the present invention is determined by measuring the amount of reflected light (reflectance) in the case of radiating light from the side of the back protective sheet 102 in which the thermoplastic resin sheet 26 is formed (side opposite from the side in which the base sheet 24 is laminated).
The reflectance is the percentage of the amount of light reflected from a measurement sample based on the amount of light reflected from a reference sample (reflectance: 100%). Here, a reference plate composed of barium sulfate (BaSO₄) is used for the reference sample.
In addition, the reflected light refers to the total of the amount of specular reflected light and the amount of scatter reflected light.

The reflectance is determined as the average value (average reflectance) of the values of reflectance obtained by measuring over the following two wavelength ranges at an interval of 1 nm.
(1) Wavelength range: 300 nm to 800 nm
(2) Wavelength range: 800 nm to 1200 nm

The basis for using the two wavelength ranges indicated above is that solar cells composed of amorphous silicon and solar cells composed of crystalline silicon typically efficiently convert light of the wavelength range of (1) and light of the wavelength range of (2) in that order, respectively, to electricity.

In the case the thermoplastic resin sheet 26 of the back protective sheet 102 of the present invention does not contain a highly reflective pigment such as titanium oxide, the average reflectance of the back protective sheet 102 is preferably within the following ranges. Namely, with respect to the aforementioned wavelength range (1), the average reflectance is preferably 10% or more, preferably 12% or more and even more preferably 13% or more. With respect to the aforementioned wavelength range (2), the average reflectance is preferably 10% or more, more preferably 12% or more, and even more preferably 13.5% or more.
If the back protective sheet 102 has a preferable average reflectance as indicated above, the electrical power generation efficiency of a solar cell module obtained by using the back protective sheet 102 can be further enhanced.

Since the back protective sheet 102 for a solar cell module of the present invention that has been explained as a first embodiment of the present invention has the thermoplastic resin sheet 26 containing the heat-expandable particles formed on at least one side of the base sheet 24, pores can be formed in the thermoplastic resin sheet 26, and as a result thereof, the light reflectivity and electrical insulating properties of the back protective sheet 102 for a solar cell module are enhanced.
Thus, in the solar cell module 100 obtained by using the back protective sheet 102 for a solar cell module, reflection efficiency of light being reflected and returning to the solar cells 104 after having escaped through gaps between the solar cells 104 can be enhanced, thereby enhancing the electrical power generation efficiency of the solar cell module. Moreover, the solar cell module is able to accommodate system voltages of 1000 V or more.

### <Second Embodiment>

FIG. 2 is a schematic cross-sectional view showing a second embodiment of a protective sheet for a solar cell module of the present invention.
As shown in FIG. 2, the back protective sheet 102 of the present invention preferably further has a fluorine-containing resin coating layer 22 formed on the side of the base sheet 24 opposite from the side on which the thermoplastic resin sheet 26 containing heat-expandable particles is formed.
Formation of this fluorine-containing resin coating layer 22 makes it possible to further improve the weather resistance of the back protective sheet 102 of the present invention.

A thermoplastic resin sheet 26 may also be formed between the fluorine-containing resin coating layer 22 and the base sheet 24. Namely, the thermoplastic resin sheet 26 may be formed on both sides of the base sheet 24, and the fluorine-containing resin coating layer 22 may be formed on one of the thermoplastic resin sheets 26.

There are no particular limitations on the fluorine-containing resin coating layer 22 provided it is a layer that contains fluorine. This fluorine-containing layer can be formed by, for example, coating a sheet having a fluorine-containing resin or a coating material having a fluorine-containing resin to obtain a coated film. Among these, a coated film obtained by coating a coating material having a fluorine-containing resin is preferable from the viewpoint of reducing the thickness of the fluorine-containing resin coating layer 22 in order to reduce the weight of the back protective sheet 102 for a solar cell module.

In the case the fluorine-containing resin coating layer 22 is a sheet having a fluorine-containing resin, the fluorine-containing resin coating layer 22 is formed on the base sheet 24 by means of an adhesive layer. The adhesive layer is composed of an adhesive that demonstrates adhesion with respect to the base sheet 24.
Examples of adhesives used to compose this adhesive layer include polyacrylic-based adhesives, polyurethane-based adhesives, epoxy-based adhesives, polyester-based adhesives and polyester-polyurethane-based adhesives. One type of these adhesives may be used alone or two or more types may be used in combination.

On the other hand, in the case the fluorine-containing resin coating layer 22 is a coated film obtained by coating a coating material having a fluorine-containing resin, the fluorine-containing resin coating layer 22 is normally formed on the base sheet 24 by directly coating a coating material containing a fluorine-containing resin on the base sheet 24 without using an adhesive layer.

Preferable examples of the fluorine-containing resin include polymers mainly composed of chlorotrifluoroethylene (CTFE) such as Lumiflon (trade name) manufactured by Asahi Glass Co., Ltd., Cefral Coat (trade name) manufactured by Central Glass Co., Ltd. or Fluonate (trade name) manufactured by DIC Corp., polymers mainly composed of tetrafluoroethylene (TFE) such as Zeffle (trade name) manufactured by Daikin Industries, Ltd., polymers having fluoroalkyl groups such as Zonyl (trade name) manufactured by E.I. Du Pont de Nemours and Company or Unidyne (trade name) manufactured by Daikin Industries, Ltd., and polymers mainly composed of fluoroalkyl units. Among these, polymers mainly composed of CTFE and polymers mainly composed of TFE are more preferable from the viewpoints of weather resistance and pigment dispersibility, while Lumiflon (trade name) and Zeffle (trade name) are most preferable.

The coating material may further contain a crosslinking agent (curing agent), catalyst (crosslinking promoter) and solvent in addition to the fluorine-containing resin, and may further contain an inorganic compound such as a pigment or filler as necessary.

There are no particular limitations on the solvent contained in the coating material provided it does not impair the effects of the present invention, and a solvent having one or more types of any of the solvents of, for example, methyl ethyl ketone (MEK), cyclohexanone, acetone, methyl isobutyl ketone (MIBK), toluene, xylene, methanol, isopropanol, ethanol, heptane, ethyl acetate, isopropyl acetate, n-butyl acetate or n-butyl alcohol can be used preferably. In particular, a solvent having one or more types of any of the solvents of xylene, cyclohexanone or MEK is more preferable from the viewpoints of solubility of the contained components in the coating material and a low rate of remaining in the coated film (low boiling point temperature).

There are no particular limitations on pigment and other additives that may be contained in the coating material provided they do not impair the effects of the present invention. Examples include titanium dioxide, carbon black, perylene pigment, colorants, dyes, mica, polyamide powder, boron nitride, zinc oxide, aluminum oxide, silica, ultraviolet absorbents, antiseptics and drying agents.

The coated film is preferably cured with a crosslinking agent to improve scratch resistance. There are no particular limitations on the crosslinking agent provided it does not impair the effects of the present invention, and examples of crosslinking agents that are used preferably include metal chelates, silanes, isocyanates and melamines. In the case of assuming that the protective sheet for a solar cell module is to be used outdoors for 30 years or more, an aliphatic isocyanate is preferable for the crosslinking agent from the viewpoint of weather resistance.
In addition, examples of catalysts that can be used include dibutyltin dilaurate and dioctyltin dilaurate, and these catalysts are used to promote crosslinking between the fluorine-containing resin and isocyanate.

In the back protective sheet 102 of the present invention exemplified in FIG. 2, a known method can be used to coat the coating material onto the base sheet 24 or the thermoplastic resin sheet 26, and for example, the coating material may be coated to a desired thickness with a bar coater (rod coater).
There are no particular limitations on the film thickness of the fluorine-containing resin coating layer 22 formed by curing the coating material provided it does not impair the effects of the present invention, and is, for example, 5 µm or more. From the viewpoints of weather resistance and light weight, the film thickness of the fluorine-containing resin coating layer 22 is preferably 5 µm to 100 µm and more preferably 10 µmto 50 µm.

The temperature during the drying process of the coated coating material is a temperature that does not impair the effects of the present invention, from the viewpoint of reducing the effect of heat on the base sheet 24 and the thermoplastic resin sheet 26, is preferably within the range of 50°C to 120°C.
Furthermore, the temperature during the drying process is preferably such that drying is carried out in a short period of time at a temperature lower than the thermal expansion starting temperature of the heat-expandable particles.

Since the back protective sheet 102 for a solar cell module of the present invention explained above as a second embodiment has the thermoplastic resin sheet 26 containing the heat-expandable particles and the fluorine-containing resin coating layer 22 formed respectively on at least one side of the base sheet 24, the weather resistance of the back protective sheet 102 for a solar cell module is further enhanced.
Thus, in addition to the superior effects realized by the solar cell module 100 obtained by using the back protective sheet 102 of the first embodiment, the solar cell module 100 obtained by using this second embodiment of the back protective sheet 102 for a solar cell module also has the effect of further enhancing weather resistance.

The solar cell module 100 of the present invention is a solar cell module obtained by using the back protective sheet 102 for a solar cell module of the present invention.
The solar cell module 100 of the present invention is formed by using the back protective sheet 102 of the present invention in combination with conventionally known components and materials that compose solar cell modules.
For example, as shown in FIG. 3, the solar cell module of the present invention is mainly composed of the solar cells 104 composed of crystalline silicon or amorphous silicon and the like, the encapsulant (filler layer) 103 composed of an electrical insulator that encapsulates the solar cells 104, the light transmissive front protective sheet (front sheet) 101 laminated on the front side of the encapsulant 103, and the back protective sheet (back sheet) 102 laminated on the back side of the encapsulant 103.
An adhesive mainly composed of a transparent resin such as ethylene-vinyl acetate copolymer (EVA), polyvinyl butyral, silicone resin, epoxy resin, fluorinated polyimide resin, acrylic resin or polyester resin can be used for the encapsulant 103.

By using the back protective sheet 102 of the present invention for the back protective sheet 102 shown in FIG. 3, and laminating on an encapsulating side composed of the encapsulant 103 containing the solar cells 104, the solar cells 104 and the encapsulant 103 in the solar cell module 100 can be protected from weather, humidity, dust and mechanical impacts and the like, and the inside of the solar cell module 100 can be maintained in an encapsulated state isolated from the outside air.
In the case the back protective sheet 102 of the present invention has the fluorine-containing resin coating layer 22, the fluorine-containing resin coating layer 22 is made to face to the outside (on the side not facing the encapsulant 103), and the thermoplastic resin sheet 26 is laminated on the encapsulating side. A known method such as vacuum thermo-compression bonding can be applied for the lamination method.
In addition, due to the heat-expandable particles contained in the thermoplastic resin sheet 26, pores are formed within the thermoplastic resin sheet 26, enabling it to function as the back protective sheet 102 of the solar cell module.

The production method of the solar cell module 100 of the present invention consists of adhering the back protective module 102 for a solar cell module to the back of the encapsulant 103 used to encapsulate the solar cells 104 by heating.
The back of the encapsulant 103 refers to the side on the opposite side from the front side of the encapsulant 103 on which the light transmissive front protective sheet 101 of the solar cell module 100 is laminated. In the present description and claims, the side of the encapsulant 103 on which the back protective sheet 102 is adhered and laminated is referred to the as the back side. In addition, the back side may also be simply referred to as the encapsulating side.
By heating the entire back protective sheet 102 by a heating device in the state in which the thermoplastic resin sheet 26 that composes the back protective sheet 102 is contacted with and compression-bonded to the back side of the encapsulant 103, in addition to causing the heat-expandable particles in the thermoplastic resin sheet 26 that composes the back protective sheet 102 to expand, thermal adhesion is demonstrated by the sheet 26, thereby enabling it to adhere to the back of the compression-contacted encapsulant 103.

The temperature at which the entire back protective sheet 102 is heated by the heating device (heating treatment temperature) is preferably 1°C or more higher, more preferably 5°C or more higher, and even more preferably 10°C or more higher than the thermal expansion starting temperature of the heat-expandable particles contained in the thermoplastic resin sheet 26. More specifically, in the case the thermal expansion starting temperature is 120°C, for example, the heating treatment temperature is preferably 121°C or higher, more preferably 125°C or higher, and even more preferably 130°C or higher. As a result of making the heating treatment temperature to be within the aforementioned ranges, simultaneous to the back protective sheet 102 being able to be adequately thermally adhered to the back side of the encapsulant 103, since the heat-expandable particles contained in the thermoplastic resin sheet 26 that composes the back protective sheet 102 are able to adequately thermally expand, pores are able to be adequately formed in the thermoplastic resin sheet 26. As a result, light reflectivity and electrical insulating properties of the back protective sheet 102 are improved as previously described.

In addition, in the case the heat-expandable particles having a temperature at which the expansion rate thereof reaches a maximum (maximum expansion temperature), the heating treatment temperature is preferably 1°C or more lower than the maximum expansion temperature. More specifically, in the case the maximum expansion temperature is 180°C, for example, the heating treatment temperature is preferably 179°C or lower. As a result of carrying out heating treatment at a temperature within the aforementioned range, simultaneous to being able to adequately thermally adhere the back protective sheet 102 to the back side of the encapsulant 103, the heat-expandable particles contained in the thermoplastic resin sheet 26 that composes the back protective sheet 102 are able to sufficiently thermally expand, and since excessive thermal expansion and rupturing of the heat-expandable particles can be suppressed, pores are sufficiently formed in the thermoplastic resin sheet 26, and since each of the formed pores easily become mutually independent, the strength of the thermoplastic resin sheet 26 can be adequately maintained. As a result, the light reflectivity and electrical insulating properties of the back protective sheet 102 are improved as previously described.

The duration of the heating treatment by the heating device is suitably adjusted according to the type of the thermoplastic resin sheet 26 that composes the back protective sheet 102 and the type of heat-expandable particles contained therein. Normally, the heating treatment can be carried out for 15 minutes to 60 minutes.
A known heating device typically used in the production of solar cell modules can be used for the heating device.

The present invention also provides a production method of a solar cell module that includes contacting a thermoplastic resin sheet of the first or second back protective sheet for a solar cell module with the back side of an encapsulant that encapsulates solar cells, and adhering the thermoplastic resin sheet by heating the back protective sheet.
In addition, the present invention provides a solar cell module having solar cells, an encapsulant that encapsulates the solar cells, and a back protective sheet laminated on the encapsulant, wherein
the back protective sheet is composed of the first or second back protective sheet for a solar cell module, and
the back protective sheet is laminated on the encapsulant through the thermoplastic resin sheet.

### [Examples]

Although the following provides a more detailed explanation of the present invention by indicating examples thereof, the present invention is not limited to the following examples.

### Example 1

### (Production of Back Protective Sheet for Solar Cell Module)

6.11 parts by weight of heat-expandable particles having a thermal expansion starting temperature of 122°C (product name: Kureha Microspheres H850D, Kureha Corp., mean particle diameter before expansion: 36 µm, maximum expansion temperature: 180°C) were added to 100 parts by weight of ethylene-vinyl acetate copolymer (EVA) dispersed in water (ethylene/vinyl acetate = 30/70, solid fraction: 55% by weight, Vicat softening temperature: <30°C, product name: Sumikaflex 401HQ, Sumika Chemtex Co., Ltd.), followed by stirring for 10 minutes using a disperser (device name: T.K. Homodisper, Primix Corp.) to prepare a dispersion solution (A).
Subseqently, the dispersion solution (A) was coated using an applicator onto a hydrolysis-resistant PET sheet having a thickness of 125 µm (product name: Melinex 238, Dupont Teijin Films, Ltd.) and then dried for 2 minutes at 90°C to prepare a thermoplastic resin sheet having a thickness of 30 µm and containing the heat-expandable particles and produce a back protective sheet for a solar cell module.

### (Production of Evaluation Sheets)

Next, after contracting and superimposing the side having the thermoplastic resin sheet of the back protective sheets for a solar cell module produced in the examples and comparative examples on an EVA sheet having a thickness of 400 µm (product name: Ultra Pearl, Sanvic Inc.), the laminate was placed between glass plates, a 100 g weight was placed thereon to press the sheets together, heating treatment was carried out for 30 minutes in an oven at 150°C, and in the case the protective sheet contained heat-expandable particles, the heat-expandable particles were allowed to expand, followed by thermo-compression bonding of the side having the thermoplastic resin sheet of the back protective sheet for a solar cell module to the EVA sheet. The resulting sheets were used as evaluation sheets.
Furthermore, the EVA sheet is corresponded to the encapsulant 103 of the solar cell module 100 of FIG. 3.

### Example 2

A back protective sheet for a solar cell module and an evaluation sheet using the back protective sheet for a solar cell module were produced in the same manner as Example 1 with the exception of changing the added amount of the heat-expandable particles (Kureha Microspheres H850D) to 2.89 parts by weight.

### Example 3

A back protective sheet for a solar cell module and an evaluation sheet using the back protective sheet for a solar cell module were produced in the same manner as Example 1 with the exception of changing the added amount of heat-expandable particles (Kureha Microspheres H850D) to 1.41 parts by weight.

### Example 4

A back protective sheet for a solar cell module and an evaluation sheet using the back protective sheet for a solar cell module were produced in the same manner as Example 1 with the exception of changing the added amount of heat-expandable particles (Kureha Microspheres H850D) to 0.56 parts by weight.

### Example 5

A back protective sheet for a solar cell module and an evaluation sheet using the back protective sheet for a solar cell module were produced in the same manner as Example 1 with the exception of preparing the dispersion solution (A) by changing the amount of the heat-expandable particles (Kureha Microspheres H850D) added to 4.23 parts by weight and further adding 25.39 parts by weight of titanium oxide (product name: Tipaque CR-50, Ishihara Sangyo Kaisha Ltd.).

### Example 6

A back protective sheet for a solar cell module and an evaluation sheet using the back protective sheet for a solar cell module were produced in the same manner as Example 5 with the exception of adding heat-expandable particles having a thermal expansion starting temperature of 138°C (product name: Kureha Microspheres H950D, Kureha Corp., mean particle diameter before expansion: 22 µm, maximum expansion temperature: 183°C) instead of the heat-expandable particles used in Example 5 (Kureha Microspheres H850D).

### Example 7

### (Preparation of Fluorine-Containing Resin Coating Agent (1))

A mixture consisting of 100 parts by weight of a CTFE-based copolymer (solid fraction: 60% by weight, trade name: Lumiflon LF200 (Asahi Glass Co., Ltd.), 10 parts by weight of an aliphatic isocyanate-based crosslinking agent (curing agent, trade name: Sumijule N3300, Sumika Bayer Urethane Co., Ltd., solid concentration: 100% by weight), 0.0001 parts by weight of dioctyltin dilaurate, 30 parts by weight of titanium oxide (trade name: Ti-Pure R105, E.I. DuPont de Nemours and Company), 18.2 parts by weight of silica (trade name: CAB-O-SIL TS-720, Cabot Corp.) and 150 parts by weight of methyl ethyl ketone (MEK) was stirred for 10 hours using a disperser (device name: T.K. Homodisper, Primix Corp.) to prepare a fluorine-containing resin coating agent (1).

### (Production of Back Protective Sheet for Solar Cell Module)

The fluorine-containing resin coating agent (1) was coated onto a hydrolysis-resistant PET sheet having a thickness of 125 µm with a Meyer bar followed by drying for 1 minute at 130°C to form a fluorine resin-containing coating layer having a thickness of 15 µm. The dispersion solution (A) prepared in Example 5 was coated onto the opposite side from the side on which the fluorine-containing resin coating layer was formed with an applicator followed by drying for 2 minutes at 90°C to prepare a thermoplastic resin sheet containing the heat-expandable particles and having a thickness of 30 µm and prepare a back protective sheet for a solar cell module.

### (Production of Evaluation Sheet)

Next, an evaluation sheet was prepared in the same manner as Example 5 using the produced back protective sheet for a solar cell module.

### Example 8

### (Preparation of Fluorine-Containing Resin Coating Agent (2))

A fluorine-containing resin coating agent (2) was prepared in the same manner as Example 7 with the exception of using a TFE-based copolymer (solid fraction: 65% by weight, trade name: Zeffle GK-570, Daikin Industries, Ltd.) instead of the CTFE-based copolymer used in Example 7.

### (Production of Back Protective Sheet for Solar Cell Module)

A back protective sheet for a solar cell module was produced in the same manner as Example 7 with the exception of using the fluorine-containing resin coating agent (2).

### (Production of Evaluation Sheet)

Next, an evaluation sheet was prepared in the same manner as Example 7 using the produced back protective sheet for a solar cell module.

### Comparative Example 1

A back protective sheet for a solar cell module, and an evaluation sheet using the back protective sheet for a solar cell module were produced in the same manner as Example 1 with the exception of not adding heat-expandable particles (Kureha Microspheres H850D).

### Comparative Example 2

A back protective sheet for a solar cell module, and an evaluation sheet using the back protective sheet for a solar cell module were produced in the same manner as Example 5 with the exception of not adding heat-expandable particles (Kureha Microspheres H850D).

The average reflectance of the evaluation sheets produced in Examples 1 to 8 and Comparative Examples 1 and 2 was measured according to the method described below. The results are shown in Table 1.

### <Method for Measuring Average Reflectance>

Light was radiated onto test pieces obtained by cutting the produced evaluation sheets to a size of 30 mm x 50 mm from the EVA side, and the average reflectance thereof was measured using a UV-visible near infrared spectrophotometer (device name: UV-3600, Shimadzu Corp.). At this time, an integrating sphere accessory ISR-3000 was used ancillary to the spectrophotometer.

In this measurement, the average reflectance was the average of the values of reflectance obtained by measuring the following two wavelength ranges at an interval of 1 nm. In addition, the reflectance was taken to be the relative value resulting from measuring scattered reflectance, which includes specular reflectance of the measured sample, based on a value of 100% for the reflectance of a reference white plate composed of BaSO₄ (reflection reference).
(1) Average reflectance over wavelength range of 300 nm to 800 nm (%)
(2) Average reflectance over wavelength range of 800 nm to 1200 nm (%)

**[Table 1]**

| | Titanium oxide content (wt%) | Heat-expandable particle content (wt%) | Average reflectance (%) | |
|---|---|---|---|---|
| | | | Wavelength range (1): 300-800 nm | Wavelength range (2): 800-1200 nm |
| Example 1 | -- | 10 | 32.4 | 38.6 |
| Example 2 | -- | 5.0 | 23.8 | 26.9 |
| Example 3 | -- | 2.5 | 17.7 | 19.2 |
| Example 4 | -- | 1.0 | 13.0 | 13.5 |
| Example 5 | 30 | 5.0 | 55.5 | 63.5 |
| Example 6 | 30 | 5.0 | 53.4 | 61.9 |
| Example 7 | 30 | 5.0 | 57.3 | 65.2 |
| Example 8 | 30 | 5.0 | 57.8 | 65.4 |
| Comp. Ex. 1 | -- | -- | 9.2 | 9.4 |
| Comp. Ex. 2 | 32 | -- | 46.0 | 53.1 |

The titanium oxide content and heat-expandable particle content shown in Table 1 indicate the weight percentages based on a value of 100% by weight for the sum of weights of the solid fractions consisting of titanium oxide, heat-expandable particles and thermoplastic resin that compose the thermoplastic resin sheet formed in each of the test examples.

Based on the results of Table 1, when Examples 1 to 4 according to the present invention are compared with Comparative Example 1, the back protective sheets for a solar cell module of Examples 1 to 4 were confirmed to demonstrate superior reflectivity.
Moreover, when Examples 5 and 6 according to the present invention are compared with Comparative Example 2, even in the case the thermoplastic resin sheets of the back protective sheets for a solar cell module contain titanium oxide, the back protective sheets for a solar cell module of Examples 5 and 6 were confirmed to demonstrate superior reflectivity.
In addition, when Example 5 according to the present invention is compared with Examples 7 and 8, each of the back protective sheets for a solar cell module was confirmed to demonstrate equally superior reflectivity regardless of the presence or absence of a fluorine-containing resin coating layer.
Thus, in the case of comparing a solar cell module obtained by using the back protective sheet for a solar cell module of the present invention with a conventional back protective sheet for a solar cell module, the electrical power generation efficiency of a solar cell module according to the present invention is clearly superior.

### Example 9

### (Production of Back Protective Sheet for Solar Cell Module)

0.7 parts by weight of heat-expandable particles having a thermal expansion starting temperature of 122°C (Kureha Microspheres H850D, Kureha Corp., mean particle diameter: 36 µm, maximum expansion temperature: 180°C) and 13.9 parts by weight of titanium oxide (trade name: Tipaque CR-50, Ishihara Sangyo Kaisha Ltd.) were added to 100 parts by weight of a ethylene- vinyl acetate copolymer (EVA) dispersed in water (ethylene/ vinyl acetate = 30/70, solid fraction: 55% by weight, Vicat softening temperature: <30°C, trade name: Sumikaflex 401HQ, Sumika Chemtex Co., Ltd.) followed by stirring for 10 minutes using a disperser (device name: T.K. Homodisper, Primix Corp.) to prepare a dispersion solution (B).
Subsequently, the dispersion solution (B) was coated using an applicator onto a hydrolysis-resistant PET sheet having a thickness of 125 µm (product name: Melinex 238, Dupont Teijin Films, Ltd.) and then dried for 2 minutes at 90°C to form a thermoplastic resin sheet having a thickness of 30 µm and containing the heat-expandable particles and produce a back protective sheet for a solar cell module.

### Example 10

A back protective sheet for a solar cell module was produced in the same manner as Example 9 with the exception of changing the amount added of the heat-expandable particles (Kureha Microspheres H850D) to 1.8 parts by weight and changing the amount added of the titanium oxide to 14.2 parts by weight.

### Example 11

A back protective sheet for a solar cell module was produced in the same manner as Example 9 with the exception of changing the amount added of the heat-expandable particles (Kureha Microspheres H850D) to 3.7 parts by weight and changing the amount added of the titanium oxide to 14.6 parts by weight.

### Example 12

A back protective sheet for a solar cell module was produced in the same manner as Example 9 with the exception of changing the amount added of the heat-expandable particles (Kureha Microspheres H850D) to 7.9 parts by weight and changing the amount added of the titanium oxide to 15.7 parts by weight.

### Example 13

A back protective sheet for a solar cell module was produced in the same manner as Example 12 with the exception of adding 7.9 parts by weight of heat-expandable particles having a thermal expansion starting temperature of 138°C (Kureha Microspheres H950D, Kureha Corp., mean particle diameter: 22 µm, maximum expansion temperature: 183°C) instead of the heat-expandable particles used in Example 12.

### Example 14

The fluorine-containing resin coating agent (1) prepared in Example 7 was coated with a Meyer bar onto a hydrolysis-resistant PET sheet having a thickness of 125 µm (trade name: Melinex 238, DuPont Teijin Films) followed by drying for 1 minute at 130°C to form a fluorine-containing resin coating layer having a thickness of 15 µm. The dispersion solution (B) prepared in Example 12 was then coated with an applicator onto the side opposite from the side on which the fluorine-containing resin coating layer was formed followed by drying for 2 minutes at 90°C to form a thermoplastic resin sheet having a thickness of 30 µm and containing heat-expandable particles (Kureha Microspheres H850D), and produce a back protective sheet for a solar cell module.

### Example 15

A back protective sheet for a solar cell module was produced in the same manner as Example 14 with the exception of not using the fluorine-containing resin coating agent (1) while instead using the fluorine-containing resin coating agent (2) prepared in Example 8.

### Comparative Example 3

A back protective sheet for a solar cell module was produced in the same manner as Example 9 with the exception of not adding heat-expandable particles (Kureha Microspheres H850D).

A partial discharge test was carried out on the back protective sheets for a solar cell module produced in Examples 9 to 15 and Comparative Example 3. The results are shown in Table 2.

### <Partial Discharge Test Method>

Partial discharge starting voltage was measured according to the alternative test method complying with the specifications of EN50178 using a tester (device name: KPD2050, Kikusui Electronics Corp.).
The specific testing conditions consisted of a maximum applied voltage of 1.2 kV or 1.6 kV, maximum applied voltage duration of 5 seconds, voltage ramp time of 10 seconds, and threshold value for the quantity of electricity of 10 pC.

**[Table 2]**

| | Titanium oxide content (wt%) | Heat-expandable particle content (wt%) | Partial discharge starting voltage (V) |
|---|---|---|---|
| Example 9 | 20 | 1.0 | 1610 |
| Example 10 | 20 | 2.5 | 1690 |
| Example 11 | 20 | 5.0 | 1780 |
| Example 12 | 20 | 10.0 | 1960 |
| Example 13 | 20 | 10.0 | 1890 |
| Example 14 | 20 | 10.0 | 2010 |
| Example 15 | 20 | 10.0 | 2030 |
| Comp.Ex.3 | 20 | -- | 1290 |

The titanium oxide content and heat-expandable particle content shown in Table 2 indicate the weight percentages based on a value of 100% by weight for the sum of weights of the solid fractions consisting of titanium oxide, heat-expandable particles and thermoplastic resin that compose the thermoplastic resin sheet deposited in each of the test examples.

Based on the results of Table 2, when Examples 9 to 13 according to the present invention are compared with Comparative Example 3, the back protective sheets for a solar cell module of Examples 9 to 13 were confirmed to demonstrate superior electrical insulating properties.
In addition, when Example 12 according to the present invention is compared with Examples 14 and 15, each of the back protective sheets for a solar cell module was confirmed to demonstrate equally superior electrical insulating properties regardless of the presence or absence of a fluorine-containing resin coating layer.
Thus, in the case of comparing a solar cell module obtained by using the back protective sheet for a solar cell module of the present invention with a conventional back protective sheet for a solar cell module, a solar cell module according to the present invention is clearly more able to accommodate high system voltages.

### INDUSTRIAL APPLICABILITY

The present invention provides a back protective sheet for a solar cell module, a solar cell module provided with the back protective sheet for a solar cell module, and a production method of a solar cell module, and is industrially useful.

### BRIEF DESCRIPTION OF THE REFERENCE SYMBOLS

100 Solar cell module
101 Light transmissing front protective sheet (front sheet)
102 Back protective sheet (back sheet)
103 Encapsulant
104 Solar cell
22 Fluorine-containing resin coating layer
24 Base sheet
26 Thermoplastic resin sheet

## Claims

1. A back protective sheet for a solar cell module in which a thermoplastic resin sheet containing heat-expandable particles is formed on at least one side of a base sheet.

2. The back protective sheet for a solar cell module according to claim 1, wherein the heat-expandable particles are contained at a ratio of 0.1% by weight to 30% by weight in the thermoplastic resin sheet.

3. The back protective sheet for a solar cell module according to claim 1, wherein the particle diameter of the heat-expandable particles prior to thermal expansion is 5 µm to 150 µm.

4. The back protective sheet for a solar cell module according to claim 1, wherein the thermal expansion starting temperature of the heat-expandable particles is equal to or higher than the softening temperature of a thermoplastic resin that composes the thermoplastic resin sheet.

5. The back protective sheet for a solar cell module according to claim 1, wherein the thermal expansion starting temperature of the heat-expandable particles is preferably within the range of 85°C to 180°C.

6. A production method of a solar cell module, comprising: contacting a thermoplastic resin sheet of the back protective sheet for a solar cell module according to any one of claims 1 to 5 to the back side of an encapsulant that encapsulates solar cells, and heating the back protective sheet.

7. A solar cell module having solar cells, an encapsulant that encapsulates the solar cells, and a back protective sheet laminated onto the encapsulant, wherein the back protective sheet is composed of the back protective sheet for a solar cell module according to any one of claims 1 to 5, and the back protective sheet is laminated onto the encapsulant through the thermoplastic resin sheet.
